(19) Europäisches Patentamt
European Patent Office
Office européen des brevets

(11) **EP 1 798 859 A1**

(12) **EUROPÄISCHE PATENTANMELDUNG**

(43) Veröffentlichungstag:
**20.06.2007 Patentblatt 2007/25**

(51) Int Cl.:
**H03L 7/197** *(2006.01)*   **H03L 7/081** *(2006.01)*

(21) Anmeldenummer: **06025399.4**

(22) Anmeldetag: **08.12.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **17.12.2005 DE 102005060472**

(71) Anmelder: **ATMEL Germany GmbH**
**74072 Heilbronn (DE)**

(72) Erfinder:
• **Beyer, Sascha**
  **01458 Ottendorf-Okrilla (DE)**
• **Jaehne, Rolf**
  **01458 Ottendorf-Okrilla (DE)**

(54) **PLL-Frequenzgenerator**

(57)   Die Erfindung betrifft einen PLL-Frequenzgenerator (20) zum Generieren eines Ausgangssignals mit einer einstellbaren Zielfrequenz, enthaltend a) einen spannungsgesteuerten Oszillator (24) zum Generieren des Ausgangssignals, b) einen mit dem spannungsgesteuerten Oszillator verbundenen schaltbaren Frequenzteiler (25), der ausgebildet ist, aus dem Ausgangssignal ein frequenzgeteiltes Signal abzuleiten, dessen Momentanfrequenz von einem Wert eines einstellbaren Teilers abhängt, c) eine mit dem Frequenzteiler verbun-dene schaltbare Verzögerungseinheit (26), die ausgebil-det ist, ein verzögertes Signal zu bilden, indem das frequenzgeteilte Signal um Verzögerungszeiten verzögert wird, die jeweils von einem Steuerwort (dT) abhängen, und d) eine mit der schaltbaren Verzögerungseinheit ver-bundene Steuereinheit (27), die ausgebildet ist, die Steu-erworte zu bestimmen. Erfindungsgemäß weist die Steu-ereinheit einen Sigma-Delta-Modulator (28) auf und ist ausgebildet, die Steuerworte (dT) in Abhängigkeit von mindestens einem vom Sigma-Delta-Modulator bereit-gestellten Signal zu bestimmen.

FIG. 2

EP 1 798 859 A1

**Beschreibung**

Die vorliegende Erfindung betrifft einen PLL-Frequenzgenerator (phase locked loop) nach dem Oberbegriff des Patentanspruchs 1. Die Erfindung betrifft weiterhin eine Sende-/EMpfangsvorrichtung und eine integrierte Schaltung mit einem solchen PLL-Frequenzgenerator.

Die Erfindung liegt auf dem Gebiet der Telekommunikation. Sie liegt insbesondere auf dem Gebiet von PLL-Frequenzgeneratoren, mit deren Hilfe Sende-/Empfangsvorrichtungen in Telekommunikationssystemen auf spektral beabstandete Trägerfrequenzkanäle zugreifen. Solche PLL-Frequenzgeneratoren leiten aus einem hochpräzisen Referenzsignal ein Ausgangssignal mit einer einstellbaren Zielfrequenz ab und stellen es als lokales Oszillatorsignal zur empfängerseitigen Herabmischung des Empfangssignals und/oder zur senderseitigen Heraufmischung bereit. Die einstellbare Zielfrequenz ist hierbei aus einer Gruppe vorgegebener Zielfrequenzwerte, dem sog. Frequenzraster, wählbar.

Entsprechen die Zielfrequenzwerte jeweils einem ganzzahligen Vielfachen der Frequenz des Referenzsignals ("Referenzfrequenz"), kann die Frequenz des Ausgangssignals im Rückkopplungszweig des Frequenzgenerators durch einen ganzzahligen Teiler geteilt werden. Aufgrund von Phasenrauschen weist das Spektrum des Ausgangssignals eines solchen "integer-N" PLL-Frequenzgenerators neben der gewünschten Spektrallinie bei der Zielfrequenz einen umgebenden Störanteil auf, der das Signal/Rausch-Verhältnis des Ausgangssignals bestimmt.

Ist jedoch z.B. der minimale Abstand zwischen zwei benachbarten Zielfrequenzwerten kleiner als die Referenzfrequenz, so wird im Rückkopplungszweig des Frequenzgenerators eine Frequenzteilung durch einen nichtganzzahligen Teiler erforderlich. Derartige Frequenzteilungen werden üblicherweise durch schaltbare Frequenzteiler (multi modulus divider, MMD) bewerkstelligt, die jeweils zeitweise Frequenzteilungen durch unterschiedliche ganzzahlige Teilerwerte vornehmen, um im zeitlichen Mittel die erforderliche nichtganzzahlige Frequenzteilung zu erreichen. Die Umschaltung zwischen unterschiedlichen ganzzahligen Teilerwerten verursacht jedoch einen zusätzlichen, zeitvarianten periodischen Phasenfehler im frequenzgeteilten Signal und damit im Spektrum des Ausgangssignals einen weiteren Störanteil in Form von Spektrallinien. Ohne weitere Maßnahmen zur Kompensation des zusätzlichen Phasenfehlers weist das Ausgangssignal eines solchen "fractional-N" PLL-Frequenzgenerators daher ein niedrigeres Signal/Rausch-Verhältnis auf als ein entsprechender integer-N PLL-Frequenzgenerator bzw. ein im Integer-Modus betriebener fractional-N PLL-Frequenzgenerator. Empfängerseitig führen solche Spektrallinien zu unerwünschten Nebenempfangsstellen.

Aus der Patentschrift US 6,064,272 ist ein fractional-N PLL-Frequenzgenerator bekannt, der im Rückkopplungszweig eine dem schaltbaren Frequenzteiler nachgeschaltete Phasenkompensationsschaltung aufweist. Diese Phasenkompensationsschaltung stellt mit Hilfe von unterschiedlich viele Verzögerungselemente enthaltenden Verzögerungsleitungen insgesamt vier unterschiedlich verzögerte Varianten des frequenzgeteilten Signals bereit, aus denen eines durch eine Kontrollschaltung ausgewählt wird, die durch einen Akkumulator gesteuert wird. Weiterhin ist eine Abstimmschaltung ("on-chip tuning circuit") mit weiteren Verzögerungselementen vorgesehen, die eine Steuerspannung für die Verzögerungselemente erzeugt.

Nachteilig ist hierbei, daß der durch die fractional-N-Teilung verursachte Störanteil im Spektrum des Ausgangssignals nur unzureichend unterdrückt und daher das Signal/Rausch-Verhältnis relativ klein ist. Durch das Schalten zwischen verzögerungsleitungen ergeben sich weitere Störanteile. Nachteilig ist weiterhin, daß der Realisierungsaufwand und der Energieverbrauch der Phasenkompensationsschaltung und der Abstimmschaltung bei höheren Frequenzauflösungen (Abstand zwischen zwei benachbarten Zielfrequenzwerten deutlich kleiner als Referenzfrequenz) und/oder bei höheren Zielfrequenzwerten beispielsweise im GHz-Bereich drastisch ansteigt und eine Implementierung des Frequenzgenerators daher unökonomisch bzw. praktisch nicht mehr möglich ist.

Vor diesem Hintergrund liegt der Erfindung die Aufgabe zugrunde, einen PLL-Frequenzgenerator anzugeben, der ein hohes Signal/Rausch-Verhältnis erreicht und auch bei höheren Frequenzauflösungen und/oder höheren Zielfrequenzwerten einfach zu implementieren und energiesparend zu betreiben ist, so daß leistungsfähige Sende-/Empfangsvorrichtungen einfach, kostengünstig und energieeffizient implementiert werden können.

Erfindungsgemäß wird diese Aufgabe gelöst durch einen PLL-Frequenzgenerator, eine Sende-/Empfangsvorrichtung und eine integrierte Schaltung mit den Merkmalen der Patentansprüche 1, 18 bzw. 19.

Der erfindungsgemäße PLL-Frequenzgenerator zum Generieren eines Ausgangssignals mit einer einstellbaren Zielfrequenz weist folgende Einheiten auf: a) einen spannungsgesteuerten oszillator zum Generieren des Ausgangssignals, b) einen mit dem spannungsgesteuerten Oszillator verbundenen schaltbaren Frequenzteiler, der ausgebildet ist, aus dem Ausgangssignal ein frequenzgeteiltes Signal abzuleiten, dessen Momentanfrequenz von einem Wert eines einstellbaren Teilers abhängt, c) eine mit dem Frequenzteiler verbundene schaltbare Verzögerungseinheit, die ausgebildet ist, ein verzögertes Signal zu bilden, indem das frequenzgeteilte Signal um Verzögerungszeiten verzögert wird, die jeweils von einem Steuerwort abhängen, und d) eine mit der schaltbaren Verzögerungseinheit verbundene Steuereinheit, die ausgebildet ist, die Steuerworte zu bestimmen, wobei die Steuereinheit einen Sigma-Delta-Modulator aufweist und ausgebildet ist, die Steuerworte in Abhängigkeit von mindestens einem vom Sigma-Delta-Modulator bereitgestellten Signal zu bestimmen.

Die erfindungsgemäße Sende-/Empfangsvorrichtung und die erfindungsgemäße integrierte Schaltung weisen jeweils einen solchen PLL-Frequenzgenerator auf.

Das Wesen der Erfindung besteht darin, einen Sigma-Delta-Modulator vorzusehen und die Steuerworte in Abhängigkeit von mindestens einem vom Sigma-Delta-Modulator bereitgestellten Signal zu bestimmen. Hierdurch wird ein hohes Signal/Rausch-Verhältnis erzielt und der durch die fractional-N-Teilung verursachte zusätzliche Phasenfehler auch bei höheren Frequenzauflösungen und/oder höheren Zielfrequenzwerten und/oder Nichtlinearitäten der verzögerungseinheit aufwandsgünstig und betriebsenergiesparend momentan kompensiert. Der nachgeschaltete Phasendetektor "sieht" daher nur noch den verbleibenden "integer-N" Phasenfehler, so daß sich mit Hilfe der Erfindung die Vorteile von integer-N Frequenzgeneratoren (geringer Phasenjitter, hohes Signal/Rausch-Verhältnis) mit denjenigen von fractional-N Frequenzgeneratoren (hohe Frequenzauflösung) verbinden lassen. Leistungsfähige integrierte Schaltungen und damit auch leistungsfähige Sende-/Empfangsvorrichtungen können deshalb einfach, kostengünstig und energieeffizient realisiert werden.

Vorteilhafte Ausgestaltungen und Weiterbildungen der Erfindung sind den abhängigen Ansprüchen sowie der Beschreibung unter Bezugnahme auf die Zeichnung zu entnehmen.

In einer vorteilhaften Ausführungsform ist die Steuereinheit mit dem Frequenzteiler verbunden und ausgebildet, die werte des einstellbaren Teilers in Abhängigkeit von mindestens einem vom Sigma-Delta-Modulator bereitgestellten Signal zu bestimmen. Indem sowohl die Steuerworte als auch der Teiler in Abhängigkeit von jeweils einem oder mehreren vom Sigma-Delta-Modulator bereitgestellten Signalen erzeugt werden, vereinfacht sich der implementierungsaufwand und verringert sich der Energieverbrauch.

In einer weiteren vorteilhaften Ausführungsform weist der Sigma-Delta-Modulator einen Akkumulator auf, der zum Akkumulieren eines Eingangssignals des Sigma-Delta-Modulators und zum Bereitstellen eines akkumulierten Signals ausgebildet ist, in dessen Abhängigkeit die Steuereinheit die Steuerworte bestimmt. Diese Ausführungsform ist einfach zu realisieren.

Vorteilhaft stellt der Akkumulator ein Überlaufsignal bereit, in dessen Abhängigkeit die Steuereinheit die Werte des einstellbaren Teilers bestimmt. Sowohl die Steuerworte als auch der Teiler werden damit aus vom Akkumulator bereitgestellten Größen abgeleitet. Dies ermöglicht einfache und energiesparend implementierungen.

In einer besonders vorteilhaften Ausführungsform weist die Steuereinheit einen Sigma-Delta-Modulator erster Ordnung auf und ist ausgebildet, die Steuerworte derart zu bestimmen, daß jedes Steuerwort mit einem Wert des akkumulierten Signals übereinstimmt. Diese Ausführungsform ist besonders einfach zu realisieren und besonders energieeffizient zu betreiben.

In einer bevorzugten Ausführungsform weist die Steuereinheit einen Sigma-Delta-Modulator zweiter oder höherer Ordnung auf, der ausgebildet ist, ein erstes Überlaufsignal und ein zweites Überlaufsignal bereitzustellen, in deren Abhängigkeit die Steuereinheit die Steuerworte bestimmt. Diese Ausführungsform weist aufgrund einer besonders effektiven Unterdrückung der relativ nah an der Zielfrequenz liegenden Spektrallinien des Störspektrums eine besonders hohe Leistungsfähigkeit (hohes Signal-/Rausch-Verhältnis) bei einer einfachen Implementierbarkeit und einem niedrigen Energieverbrauch auf.

Vorteilhaft bestimmt die Steuereinheit die Steuerworte in Abhängigkeit von einem ersten Differenzsignal aus dem ersten Überlaufsignal und dem zweiten Überlaufsignal.

In einer weiteren sehr vorteilhaften Ausführungsform bestimmt die Steuereinheit die Steuerworte in Abhängigkeit von einem zweiten Differenzsignal aus dem akkumulierten Signal und dem ersten Differenzsignal. Vorteilhaft ist die Steuereinheit ausgebildet, Werte des zweiten Differenzsignals im Akkumulator zu speichern.

Sehr vorteilhaft stimmt jedes Steuerwort bis auf einen Offsetwert mit je einem Wert des zweiten Differenzsignals überein. Durch die Addition des konstanten Offsetwertes zu den Werten des zweiten Differenzsignals wird erreicht, daß sämtliche Steuerworte positive Verzögerungszeiten nach sich ziehen.

In einer sehr vorteilhaften Ausführungsform weist die Steuereinheit zur Bestimmung der Steuerworte eine mit dem Sigma-Delta-Modulator und der schaltbaren verzögerungseinheit verbundene Bestimmungseinheit mit mindestens einem Addierer/Subtrahierer auf. Dies ermöglicht besonders einfache Implementierungen.

In einer besonders vorteilhaften Ausführungsform weist der Sigma-Delta-Modulator eine Ordnung von zwei auf. Diese Ausführungsform weist eine hohe Leistungsfähigkeit bei einer sehr einfachen Implementierbarkeit und einem sehr niedrigen Energieverbrauch auf.

In einer weiteren sehr vorteilhaften Ausführungsform ist die Steuereinheit ausgebildet, die Steuerworte in Abhängigkeit vom verzögerten Signal bereitzustellen. Dies ermöglicht es der Verzögerungseinheit, zu besonders vorteilhaften Zeitpunkten auf die jeweils neue dem aktuellen Steuerwort entsprechende Verzögerungszeit umzuschalten, so daß der durch die fractional-N-Teilung eingeführte zusätzliche Phasenfehler besonders präzise kompensiert wird.

In einer sehr vorteilhaften Ausführungsform ist die steuereinheit ausgebildet, die Steuerworte in zeitlicher Übereinstimmung mit jeweils einer Flanke des verzögerten Signals bereitzustellen, z.B. mit einer ansteigenden oder einer fallenden Flanke. Hierdurch wird eine optimale Kompensation des zusätzlichen Phasenfehlers und daher ein maximales Signal/Rausch-Verhältnis erreicht.

Vorzugsweise weist die Steuereinheit zum Bereitstellen der Steuerworte ein durch das verzögerte Signal getaktetes Latch auf. Hierdurch ergibt sich eine besonders aufwandsgünstige Realisierung.

Die Erfindung wird nachfolgend anhand der in den schematischen Figuren der Zeichnung angegebenen Ausführungsbeispiele näher erläutert. Hierbei zeigen

Fig. 1 Beispiel eines "Wireless Personal Area Network" (WPAN) nach IEEE 802.15.4 mit erfindungsgemäßen Sende-/Empfangsvorrichtungen;

Fig. 2 Ausführungsbeispiele erfindungsgemäßer PLL-Frequenzgeneratoren;

Fig. 3 Steuereinheit eines ersten Ausführungsbeispiels, und

Fig. 4 Steuereinheit eines zweiten Ausführungsbeispiels.

In den Figuren sind gleiche und funktionsgleiche Elemente und Signale - sofern nicht anders angegeben - mit denselben Bezugszeichen versehen.

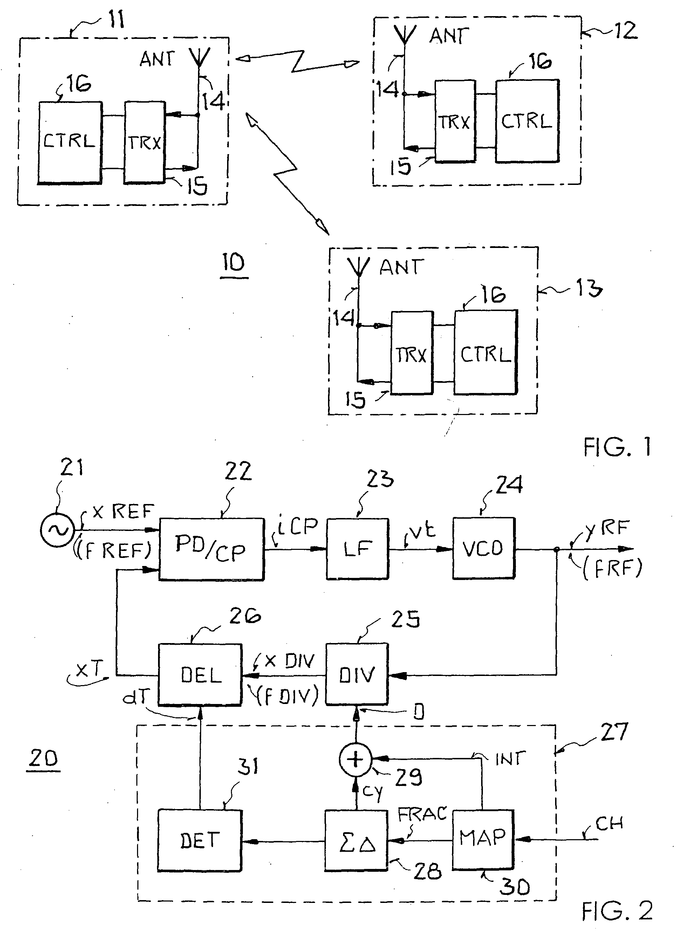

Zur drahtlosen Übertragung von Informationen über relativ kurze Distanzen können sog. "Wireless Personal Area Networks" (WPAN) verwendet werden. Fig. 1 zeigt ein Beispiel eines WPANs 10 nach dem Standard IEEE 802.15.4. Dieser Standard spezifiziert niederratige WPANs, die mit Rohdatenraten bis max. 250 kbit/s und ortsfesten oder mobilen Geräten für Anwendungen in der industriellen Überwachung und Steuerung, in Sensornetzwerken, in der Automatisierung sowie im Bereich der Computerperipherie und für interaktive Spiele geeignet sind. Neben einer sehr einfachen und kostengünstigen implementierbarkeit der Geräte ist für derartige Anwendungen ein extrem geringer Energiebedarf der Geräte von entscheidender Bedeutung. So werden mit diesem Standard Batterielaufzeiten von mehreren Monaten bis zu mehreren Jahren angestrebt.

Das in Figur 1 dargestellte WPAN umfaßt drei Sende-/Empfangsvorrichtungen 11-13 in Form von ortsfesten oder mobilen Geräten, die mittels Funksignalen drahtlos Informationen austauschen. Bei der Sende-/Empfangsvorrichtung 11 handelt es sich um ein sog. Vollfunktionsgerät, das die Funktion des WPAN-Koordinators übernimmt, während es sich bei den sende-/Empfangsvorrichtungen 12, 13 um sog. Teilfunktionsgeräte handelt, die dem Vollfunktionsgerät 11 zugeordnet sind und nur mit diesem Daten austauschen können. Neben der in Fig. 1 dargestellten sternförmigen Netzwerktopologie, bei der die bidirektionale Datenübertragung nur zwischen jeweils einem der Teilfunktionsgeräte 12, 13 und dem Vollfunktionsgerät 11, nicht jedoch zwischen den Teilfunktionsgeräten 12, 13 erfolgen kann, sieht der Standard auch sog. "Peer-to-Peer"-Topologien vor, bei denen sämtliche Vollfunktionsgeräte mit jeweils allen anderen Vollfunktionsgeräten kommunizieren können.

Die Sende-/Empfangsvorrichtungen 11-13 umfassen jeweils eine Antenne 14, eine mit der Antenne verbundene Sende-/Empfangseinheit (transceiver, TRX) 15 zum Senden und Empfangen von Daten nach IEEE 802.15.4 und eine mit der Sende-/Empfangseinheit verbundene Kontrolleinheit (control unit, CTRL) 16 zur Steuerung der Sende-/Empfangseinheit 15 gemäß IEEE 802.15.4. Weiterhin beinhalten die Sende-/Empfangsvorrichtungen 11-13 jeweils eine in Fig. 1 nicht dargestellte Energieversorgungseinheit in Form einer Batterie etc. zur Energieversorgung der Einheiten 15, 16, sowie evtl. weitere Komponenten (Sensoren, Aktoren etc.).

Im folgenden wird davon ausgegangen, daß die Datenübertragung im lizenzfreien ISM-Band (industrial, scientific, medical) bei 2,4 GHz erfolgt. In diesem Frequenzband sieht der IEEE-Standard 802.15.4 insgesamt 16 Kanäle im Abstand von jeweils 5 MHz vor. Für Rohdatenraten von $f_B=250$ kbit/s ist in diesen Kanälen eine Bandspreizung (Spreading) mit einer Chiprate von $f_C=2$ Mchip/s sowie eine Offset-QPSK-Modulation (quarternary phase shift keying) spezifiziert.

Die Sendeeinheit jeder Sende-/Empfangseinheit 15 wandelt den jeweils zu übertragenden Datenstrom in ein über ihre Antenne 14 abzustrahlendes Funksignal um, indem der zu sendende Datenstrom gemäß IEEE 802.15.4 zunächst in vier Bit breite Symbole und diese in aufeinanderfolgende PN-Sequenzen (pseudo noise) aus jeweils 32 Chips umgesetzt werden. Die Chips der aufeinanderfolgenden PN-Sequenzen werden anschließend Offset-QPSK-moduliert (quarternary phase shift keying), spektral mit Hilfe eines erfindungsgemäßen PLL-Frequenzgenerators in einen der 16 Kanäle im ISM-Frequenzband verschoben und schließlich für die Übertragung verstärkt. Da eine Offset-QPSK-Modulation mit Halbsinus-Impulsformung einer MSK-Modulation (minimum shift keying), d.h. einer FSK-Modulation (frequency shift keying) mit Modulationsindex 1/2 bzw. Frequenzhub $\Delta F=f_C/4= 0,5$ MHz entspricht, kann der PLL-Frequenzgenerator im Rahmen einer direkten Frequenzmodulation auch den hierfür notwendigen Frequenzversatz durch das Modulationssignal berücksichtigen.

Die Empfangseinheit jeder Sende-/Empfangseinheit 15 wandelt ein von ihrer Antenne 14 empfangenes und von der Sendeeinheit einer anderen Sende-/Empfangsvorrichtung nach IEEE 802.15.4 erzeugtes Funksignal möglichst fehlerfrei in die gesendeten Daten um, indem das empfangene Funksignal verstärkt, mit Hilfe des vorstehend genannten PLL-Frequenzgenerators spektral in das Basisband oder in einen Zwischenfrequenzbereich verschoben und dann demoduliert wird und schließlich die Daten detektiert werden.

Die Sende-/Empfangseinheit 15 ist hierbei jeweils Teil einer (in Figur 1 nicht dargestellten) integrierten Schaltung, z.B. eines ASICs (application specific integrated circuit) oder eines ASSPs (application specific standard product), während die Kontrolleinheit 16 jeweils durch einen (ebenfalls nicht dargestellten) Mikrocontroller realisiert ist. Vorteilhaft weist jede Sende-/Empfangsvorrichtung nur eine (z.B. als ASIC oder ASSP ausgeführte) integrierte Schaltung auf, die die Funktionen ihrer Sende-/Empfangseinheit 15 und ihrer Kontrolleinheit 16 wahrnimmt.

Figur 2 zeigt ein Blockschaltbild eines erfindungsgemäßen PLL-Frequenzgenerators für eine Sende-/Empfangseinheit 15 aus Figur 1. Der PLL-Frequenzgenerator 20 weist einen Referenzoszillator 21, einen Phasen(differenz)detektor/Ladungspumpe (phase detector/charge pump, PD/ CP) 22, ein Schleifenfilter (loop filter, LF) 23, einen spannungsgesteuerten Oszillator (voltage controlled oscillator, VCO) 24, einen schaltbaren Frequenzteiler (DIV) 25, eine schaltbare Verzögerungseinheit (DEL) 26 und eine Steuereinheit 27 auf.

Der Referenzoszillator 21 generiert ein ggf. verstärktes Referenzsignal xREF mit einer Referenzfrequenz fREF und ist z.B. als Quarzoszillator oder als spannungsgesteuerter Quarzoszillator ausgeführt.

Die PD/CP-Einheit 22 (Phasen(differenz)detektor/Ladungspumpe) weist einen mit dem Referenzoszillator 21 verbundenen ersten Eingang sowie einen mit dem Ausgang der Verzögerungseinheit 26 verbundenen zweiten Eingang auf. Die PD/CP-Einheit bestimmt die Phasenabweichung (Phasendifferenz) zwischen dem am ersten Eingang anliegenden Referenzsignal xREF und dem am zweiten Eingang anliegenden verzögerten Signal xT und stellt an ihrem Ausgang in Abhängigkeit von der Phasenabweichung einen definierten Strom iCP bereit. Anstelle des Phasendetektors kann auch ein Phasenfrequenzdetektor vorgesehen sein.

Das Schleifenfilter (LF) 23 weist einen mit der PD/CP-Einheit 22 verbundenen Eingang und einen mit dem VCO 24 verbundenen Ausgang auf. In Abhängigkeit von dem am Eingang anliegenden Strom iCP generiert das Schleifenfilter 23 eine Steuerspannung vt und stellt diese an seinem Ausgang bereit.

Der spannungsgesteuerte Oszillator (VCO) 24 weist einen mit dem Schleifenfilter 23 verbundenen Eingang und einen mit dem Frequenzteiler 25 verbundenen Ausgang auf. In Abhängigkeit von der am Eingang anliegenden Steuerspannung vt generiert der VCO 24 ein ggf. zusätzlich verstärktes Ausgangssignal yRF mit einer einstellbaren und z.B. von einem Kanalindex CH abhängigen Zielfrequenz fRF und stellt es an seinem Ausgang bereit. Die Steilheit der Frequenz-/Steuerspannungskennlinie des VCO 24 beträgt beispielsweise 40 MHz/V.

Der schaltbare Frequenzteiler (DIV) 25 weist einen mit dem VCO 24 verbundenen Signaleingang sowie einen mit der Steuereinheit 27 verbundenen Steuereingang auf. Der Frequenzteiler 25 leitet aus dem an seinem Signaleingang anliegenden VCO-Ausgangssignal yRF ein frequenzgeteiltes Signal xDIV ab, dessen Momentanfrequenz fDIV nach fDIV=fRF/D vom aktuellen Wert des an seinem Steuereingang anliegenden einstellbaren Teilers D abhängt und stellt das frequenzgeteilte Signal xDIV an seinem Ausgang bereit.

Der Wert, den der Teiler annimmt, hängt von der einstellbaren Zielfrequenz fRF bzw. dem entsprechenden Kanalindex CH sowie von der Referenzfrequenz fREF des Referenzsignal xREF ab. ist z.B. die Differenz zwischen den Zielfrequenzen zweier spektral benachbarter Kanäle, d.h. das Kanalraster, kleiner als die Referenzfrequenz fREF (man spricht in diesem Falle auch von einer "feinen" Frequenzauflö-sung), so nimmt der Teiler zumindest für manche Zielfrequenzen einen nichtganzzahligen Wert an. Im exemplarischen Falle einer Referenzfrequenz von fREF=16 MHz ergibt sich gemäß IEEE 802.15.4 für die niedrigste Zielfrequenz (fRF=2405 MHz) im ISM-Band beispielsweise der Teilerwert fRF/fREF = 150,3125.

Um derartige nichtganzzahlige Teilerwerte zu realisieren, ist der Frequenzteiler 25 schaltbar ausgeführt, wobei er jeweils zeitweise Frequenzteilungen mit unterschiedlichen ganzzahligen Teilerwerten D derart vornimmt, daß sich über ein gewisses Zeitintervall betrachtet "im Mittel" der erforderliche nichtganzzahlige Teilerwert ergibt. Frequenzgeneratoren mit einem solchen schaltbaren Frequenzteiler werden als fractional-N PLL-Frequenzgeneratoren bezeichnet.

Die Variation der Werte des Teilers D verursacht einen zeitvarianten Phasenfehler zwischen dem frequenzgeteilten Signal xDIV und dem Referenzsignal xREF, der das VCO-Ausgangssignal yRF über das Schleifenfilter 23 moduliert ("Störmodulation"). Zusätzlich zum Störanteil infolge von Phasenrauschen, der auch bei integer-N PLL-Frequenzgeneratoren vorhanden ist, weist das Spektrum des VCO-Ausgangssignals yRF bei fractional-N PLL-Frequenzgeneratoren infolge dieses zeitvarianten periodischen Phasenfehlers einen weiteren Störanteil in Form von Spektrallinien um die Zielfrequenz fRF auf, der vom nichtganzzahligen Anteil des im Mittel zu realisierenden nichtganzzahligen Teilerwertes abhängt. Erfindungsgemäß werden diese Spektrallinien weitgehend unterdrückt.

Vorzugsweise ist der Frequenzteiler 25 als sog. multi modulus divider (MMD), d.h. als digitaler, im Zählbereich programmierbarer Zähler, realisiert. Vorteilhaft besteht der MMD aus zwei Frequenzteilern, wobei der erste auch als Prescaler bezeichnet wird und ausgebildet ist, Frequenzteilungen durch N oder N+1 vorzunehmen und der zweite mit einem üblicherweise festen Teilerverhältnis arbeitet und den Moduluseingang des Prescalers in Abhängigkeit des am Steuereingang anliegenden Teilers D steuert.

Die schaltbare verzögerungseinheit (DEL) 26 weist einen mit dem Frequenzteiler 25 verbundenen Signaleingang sowie einen mit der Steuereinheit 27 verbundenen Steuereingang auf. Die verzögerungseinheit 26 bildet ein verzögertes Signal xT, indem das an ihrem Signaleingang anliegende frequenzgeteilte Signal xDIV um Verzögerungszeiten ΔT verzögert wird, die jeweils von einem an ihrem Steuereingang anliegenden digitalen Steuerwort dT abhängen und stellt das verzögerte Signal xT an ihrem Ausgang bereit. Die Verzögerungszeit $\Delta T$ hängt hierbei im wesentlichen linear vom entsprechenden Steuerwort dT ab

$$\Delta T = t0 + dT*ts \qquad , \qquad\qquad (1)$$

wobei t0 eine Grundverzögerung von z.B. ca. 1ns und ts die von der Frequenzauflösung abhängige Schrittweite der Verzögerung bezeichnen. Bei einer exemplarischen Breite der Steuerworte von 7 Bit ist es so möglich, mit jedem Steuerwort dT eine von insgesamt 128 unterschiedlichen verzögerungszeiten $\Delta T$ einzustellen. Innerhalb der Verzögerungseinheit 26, die vorzugsweise auf der Basis eines CMOS-Buffers realisiert ist, wird das Steuerwort dT in einen Strom oder eine Spannung umgesetzt, der/die die entsprechende Verzögerungszeit $\Delta T$ einstellt. Die Steuerworte dT werden von der Steuereinheit 27 so bestimmt und bereitgestellt, daß die resultierenden verzögerungszeiten $\Delta T$ geeignet sind, den oben erläuterten zeitvarianten Phasenfehler momentan zu kompensieren.

Die Steuereinheit 27 weist einen Eingang zum Zuführen eines die Zielfrequenz fRF bestimmenden Parameters wie z.B. eines Kanalindizes CH auf. In Abhängigkeit vom Kanalindex CH bestimmt die Steuereinheit 27 die Steuerworte dT und stellt sie an ihrem mit dem Steuereingang der Verzögerungseinheit 26 verbundenen ersten Ausgang bereit. Vorzugsweise bestimmt die Steuereinheit 27 außerdem die Werte des einstellbaren Teilers D in Abhängigkeit vom Kanalindex CH und stellt sie an ihrem mit dem Steuereingang des Frequenzteilers 25 verbundenen zweiten Ausgang bereit.

Die Steuereinheit 27 weist einen Sigma-Delta-Modulator ($\Sigma\Delta$) 28, einen Addierer 29, eine Mapping-Einheit (MAP) 30 und eine Bestimmungseinheit (DET) 31 zum Bestimmen der Steuerworte dT auf. Der Mapping-Einheit 30 wird eingangsseitig der Kanalindex CH zugeführt. Ausgangsseitig ist die Mapping-Einheit mit dem Sigma-Delta-Modulator 28 und einem ersten Eingang des Addierers 29 verbunden. Eingangsseitig ist der Addierer 29 an seinem zweiten Eingang mit dem Sigma-Delta-Modulator 28 und ausgangsseitig über den zweiten Ausgang der Steuereinheit 27 mit dem Frequenzteiler 25 verbunden. Der Sigma-Delta-Modulator 28 ist eingangsseitig mit der Mapping-Einheit 30 und ausgangsseitig mit dem zweiten Eingang des Addierers 29 sowie mit der dT-Bestimmungseinheit 31 verbunden. Die dT-Bestimmungseinheit 31 ist eingangsseitig mit dem Sigma-Delta-Modulator 28 und ausgangsseitig über den ersten Ausgang der Steuereinheit 27 mit der schaltbaren verzögerungseinheit 26 verbunden.

Die Mapping-Einheit 30 leitet aus dem Kanalindex CH die werte INT und FRAC ab. Die Werte INT und FRAC geben hierbei zusammen an, mit welchem Faktor die Referenzfrequenz fREF multipliziert werden muß, um die in Anbetracht des Kanalindizes CH gewünschte Zielfrequenz fRF zu erreichen. Die Werte INT und FRAC werden so bestimmt, daß die folgende Gleichung gilt:

$$(INT + FRAC/RES) * fREF = fRF \quad . \qquad\qquad (2)$$

Der Parameter RES bestimmt hierbei die Frequenzauflösung des Frequenzgenerators. Je höher der Wert des Parameters RES ist, umso höhere Frequenzauflösungen werden erzielt, d.h. umso feiner ist das Frequenzraster bzw. umso enger benachbart sind die einstellbaren Zielfrequenzen. Mit den exemplarischen Werten RES=32 und fREF=16 MHz sind z.B. Zielfrequenzen im Abstand von fREF/RES =0,5 MHz einstellbar, was im vergleich zur Referenzfrequenz fREF einer hohen Frequenzauflösung entspricht. Der Parameter FRAC nimmt in diesem Fall einen Wert zwischen null und RES-1=31 an und kann daher durch ein 5 Bit breites Wort repräsentiert werden. Die Schrittweite ts der durch die Verzögerungseinheit 26 einzustellenden Verzögerungszeiten $\Delta T$ gemäß Gleichung (1) beträgt vorteilhaft ts=1/(fRF*RES) $\approx$0,012ns.

Wird der PLL-Frequenzgenerator 20 senderseitig zur direkten Frequenzmodulation verwendet, so wird der Mapping-Einheit 30 außerdem das Modulationssignal zugeführt (nicht in den Figuren dargestellt). In Abhängigkeit von den Werten des Modulationssignals ergeben sich nun ggf. veränderte Zielfrequenzwerte fRF und damit gemäß Gleichung (2) veränderte FRAC-/INT-Werte. Damit hängen auch die Werte des Teilers D und der Steuerworte dT vom Modulationssignal ab. Im Falle der o.g. exemplarischen Werte und eines zweistufigen Modulationssignals mit einem Frequenzhub von $\Delta F$=0,5 MHz verändert sich im allg. nur der FRAC-Wert um $\pm 1$ in Abhängigkeit vom aktuellen Wert des Modualtionssignals. Das Modulationssignal kann außerdem einem schaltbar ausgeführten Schleifenfilter zugeführt werden, um ein schnelleres Einschwingen zu erreichen.

Der Sigma-Delta-Modulator 28, dem der FRAC-Wert zugeführt wird, ermittelt im einfachsten Falle eines Sigma-Delta-Modulators erster Ordnung (M=1) eine Folge cy von binären Werten (null und eins), deren relative Häufigkeit den Wert FRAC/RES widerspiegelt. Mit den o.g. exemplarischen Werten von RES und fREF führt beispielsweise der Wert FRAC=16, der gemäß Gleichung (2) für einen Frequenzoffset von 16*fREF/RES = 16*0,5 MHz = 8 MHz steht, auf eine Folge cy aus Null- und Einswerten, deren Anzahlen übereinstimmen. Analog hierzu führen die FRAC-Werte 0 bzw. 31 auf eine Folge cy von Nullwerten entsprechend einem verschwindenden Frequenzoffset bzw. auf eine Folge cy von Einswerten entsprechend einem Frequenzoffset von 31*0,5 MHz = 15,5 MHz.

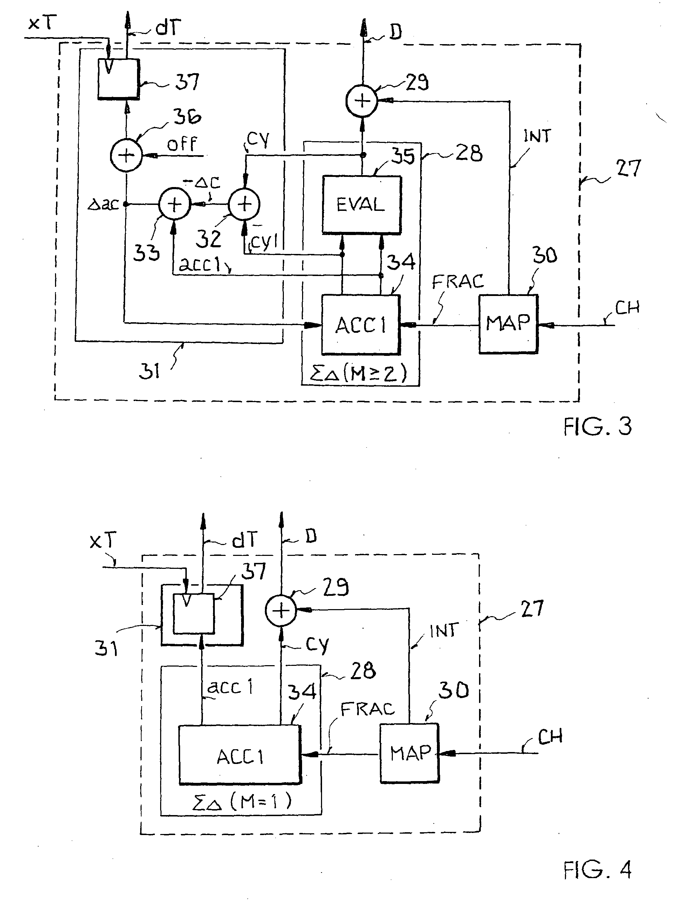

Anstelle von zweistufigen Folgen mit binären Werten können mit Hilfe eines Sigma-Delta-Modulators der Ordnung zwei oder höher ($M \geq 2$) auch höherstufige Folgen cy z.B. mit ganzzahligen Werten zwischen -1 und 2 (für M=2) erzeugt werden. In einem ersten Ausführungsbeispiel des erfindungsgemäßen PLL-Frequenzgenerators 20, das nachstehend mit Bezug auf Fig. 3 näher erläutert wird, weist der Sigma-Delta-Modulator 28 eine Ordnung von $M \geq 2$, in einem zweiten Ausführungsbeispiel, das nachstehend mit Bezug auf Fig. 4 detaillierter beschrieben wird, eine Ordnung von M=1 auf. Das Ausgangssignal des Sigma-Delta-Modulators 28 wird in beiden Fällen als erstes Überlaufsignal cy bezeichnet.

Im Addierer 29 werden die vom Sigma-Delta-Modulator 28 erzeugten cy-Werte schließlich zum INT-Wert addiert und die Summenwerte INT+cy als zeitvarianter Teiler D dem schaltbaren Frequenzteiler 25 zugeführt. Mit Hilfe dieses zeitvarianten Teilers D, der im zeitlichen Mittel dem Faktor INT+FRAC/RES aus Gleichung (2) entspricht, realisiert der Frequenzteiler 25 die erforderliche Frequenzteilung.

Die Frequenzteilung durch einen zeitvarianten Teiler D=INT+cy bewirkt einen zusätzlichen zeitvarianten Phasenfehler, der durch die schaltbare Verzögerungseinheit 26 momentan kompensiert wird, indem die Steuereinheit 27 die Steuerworte dT erfindungsgemäß bestimmt und dem Steuereingang der Verzögerungseinheit 26 zuführt. Die Steuerworte dT hängen von mindestens einem vom sigma-Delta-Modulator 28 bereitgestellten Signal ab. Um welches Signal bzw. um welche Signale es sich hierbei handelt, wird nachstehend mit Bezug auf die Figuren 3 und 4 näher erläutert.

Mit Hilfe des Sigma-Delta-Modulators können relativ nah an der Zielfrequenz liegende Spektrallinien im Störanteil des Spektrums des VCO-Ausgangssignals sehr effektiv unterdrückt werden, so daß sich ein besonders hohes Signal/Rausch-Verhältnis im Nutzfrequenzbereich ergibt. Zusätzlich unterdrückt der sigma-Delta-Modulator Störungen, die durch eventuelle Nichtlinearitäten der Verzögerungseinheit 26 hervorgerufen werden, was insbesondere dann von Vorteil ist, wenn das Verhältnis FRAC/RES einen Wert nahe null oder eins annimmt.

Figur 3 zeigt ein Blockschaltbild einer Steuereinheit 27 des ersten Ausführungsbeispiels eines erfindungsgemäßen PLL-Frequenzgenerators. Der Sigma-Delta-Modulator, der Addierer, die Mapping-Einheit und die dT-Bestimmungseinheit sind in Figur 3 wiederum mit den Bezugszeichen 28-31 bezeichnet. In Figur 3 weist der Sigma-Delta-Modulator 28 eine Ordnung von zwei oder höher auf ($M \geq 2$).

Der Sigma-Delta-Modulator 28 weist einen eingangsseitigen Akkumulator (ACC1) 34 und eine nachgeschaltete Auswertungseinheit (EVAL) 35 auf. Der beispielsweise 5 Bit breite Akkumulator 34 akkumuliert die werte des Eingangssignals FRAC des Sigma-Delta-Modulators und stellt akkumulierte Werte in einem akkumulierten Signal acc1 sowie einen Überlauf anzeigende "carry"-Werte in einem zweiten Überlaufsignal cy1 bereit. Die Auswertungseinheit 35 leitet aus dem akkumulierten Signal acc1 und dem zweiten Überlaufsignal cy1 das erste Überlaufsignal cy ab und stellt es als Ausgangssignal des Sigma-Delta-Modulator sowohl für den Addierer 29 als auch für die dT-Bestimmungseinheit 31 bereit. Je nach Ordnung des Sigma-Delta-Modulators enthält die Auswertungseinheit eine Anzahl weiterer Akkumulatoren sowie zusätzliche Logik/Kombinatorik. Das Ausgangssignal cy des Sigma-Delta-Modulators entspricht hierbei einer Kombination der Überlaufsignale verschiedener Akkumulatoren.

Die Berechnung der Steuerworte basiert auf folgenden Erkenntnissen: Die Änderung des zeitvarianten Phasenfehlers über der Zeit ist proportional zur Änderung des Inhalts des Akkumulators 34. Daher ist zur Bestimmung der Steuerworte dT die Momentanablage und der aktuelle Akkumulatorinhalt heranzuziehen.

Die dT-Bestimmungseinheit 31 weist folgende in Reihe geschaltete Einheiten auf: einen ersten Addierer/Subtrahierer 32, einen zweiten Addierer/Subtrahierer 33, einen dritten Addierer/Subtrahierer 36 und ein Latch 37. Der eingangsseitig mit dem Akkumulator 34 und der Auswertungseinheit 35 des Sigma-Delta-Modulators 28 verbundene erste Addierer/Subtrahierer 32 subtrahiert die Werte des zweiten Überlaufsignals cy1 von den Werten des ersten Überlaufsignals cy und stellt an seinem Ausgang das erste Differenzsignal $\Delta C=Cy-Cy1$ bereit. Der eingangsseitig mit dem Akkumulator 34 und dem ersten Addierer/Subtrahierer 32 verbundene zweite Addierer/Subtrahierer 33 subtrahiert die Werte des ersten Differenzsignals $\Delta c$ von den Werten des akkumulierten Signals acc1 und stellt an seinem Ausgang das zweite Differenzsignal

$$\Delta ac = acc1 - \Delta c = acc1 - (cy - cy1) = acc1 - cy + cy1 \qquad (3)$$

bereit. Anstelle der zwei Addierer/Subtrahierer 32,33 mit jeweils zwei Eingängen kann auch ein einziger Addierer/Subtrahierer mit drei Eingängen für die Signale cy, cy1 und acc1 vorgesehen werden, um die $\Delta ac$-Werte zu berechnen.

Die $\Delta ac$-Werte werden sowohl im Akkumulator 34 gespeichert als auch zur Bestimmung der Steuerworte dT verwendet. Der eingangsseitig mit dem zweiten Addierer/Subtrahierer 33 verbundene dritte Addierer/Subtrahierer 36 addiert einen konstanten positiven Offset off zu den $\Delta ac$-Werten und stellt an seinem Ausgang die Summenwerte $\Delta ac+off$

bereit. Dies stellt sicher, daß sämtliche Steuerworte dT auch dann positiven verzögerungszeiten ∆T entsprechen, wenn einer oder mehrere der ∆ac-Werte ohne Offset-Korrektur auf eine negative Verzögerungszeit ∆T führen würde(n). Die Summenwerte ∆ac+off werden schließlich dem eingangsseitig mit dem dritten Addierer/Subtrahierer 36 verbundenen Latch 37 zugeführt, das an seinem Ausgang die Steuerworte dT bereitstellt (Bitbreite z.B. 7 Bit) und vorzugsweise mit dem verzögerten Signal xT getaktet ist. Auf diese Weise werden die Steuerworte dT in zeitlicher Übereinstimmung mit jeweils einer Flanke des verzögerten Signals xT bereitgestellt, z.B. mit jeweils einer steigenden Flanke von xT. Hierdurch wird eine optimale momentane Korrektur des zeitvarianten Phasenfehlers ermöglicht. Alternativ kann das Latch 37 mit dem frequenzgeteilten Signal xDIV getaktet sein.

Die in Fig. 3 dargestellte Steuereinheit 27 bestimmt die Steuerworte dT also in Abhängigkeit vom akkumulierten Signal acc1 sowie von den Überlaufsignalen cy, cy1 (bzw. deren Differenzsignal ∆c), d.h. in Abhängigkeit von insgesamt drei vom Sigma-Delta-Modulator bereitgestellten Signalen und stellt die Steuerworte dT für die Verzögerungseinheit 26 bereit (siehe Fig. 2). Wie bereits mit Bezug auf Figur 2 erläutert, bestimmt die Steuereinheit 27 neben den Steuerworten dT vorzugsweise auch die Werte des einstellbaren Teilers D in Abhängigkeit von mind. einem vom Sigma-Delta-Modulator bereitgestellten Signal, nämlich dem Überlaufsignal cy bzw. dem akkumulierten Signal acc1 und dem Überlaufsignal cy1.

Das mit Bezug auf die Figuren 2 und 3 beschriebene erste Ausführungsbeispiel eines erfindungsgemäßen PLL-Frequenzgenerators weist aufgrund einer besonders effektiven Unterdrückung der relativ nah an der Zielfrequenz liegenden Spektrallinien des Störspektrums eine besonders hohe Leistungsfähigkeit (hohes Signal/Rausch-Verhältnis) bei einer einfachen implementierbarkeit und einem niedrigen Energieverbrauch auf.

In einer besonders bevorzugten Ausführungsform weist der Sigma-Delta-Modulator 28 eine Ordnung von zwei auf (M=2). Diese Ausführungsform weist eine hohe Leistungsfähigkeit bei einer sehr einfachen Implementierbarkeit und einem sehr niedrigen Energieverbrauch auf. Durch Messungen bestätigte Simulationen der Anmelderin haben ergeben, daß die Störmodulationen in diesem Fall um über 30 dB unterdrückt werden.

Figur 4 zeigt ein Blockschaltbild einer Steuereinheit 27 des zweiten Ausführungsbeispiels eines erfindungsgemäßen PLL-Frequenzgenerators. Der Sigma-Delta-Modulator, der Addierer, die Mapping-Einheit, die dT-Bestimmungseinheit, der Akkumulator und das Latch sind in Figur 4 wiederum mit den Bezugszeichen 28-31, 34 bzw. 37 bezeichnet. In Figur 4 weist der Sigma-Delta-Modulator 28 eine Ordnung von eins auf (M=1).

Im Falle eines Sigma-Delta-Modulators erster Ordnung stimmt das erste Überlaufsignal cy mit dem zweiten Überlaufsignal cy1 gemäß Figur 3 überein, so daß die Auswertungseinheit 35 aus Figur 3 entfällt und der beispielsweise 5 Bit breite Akkumulator 34 gemäß Figur 4 neben dem akkumulierten Signal acc1 nunmehr auch direkt das Ausgangssignal cy des Sigma-Delta-Modulators 28 bereitstellt. Bei übereinstimmenden Überlaufsignalen cy, cy1 ergibt sich weiterhin ein verschwindendes erstes Differenzsignal ∆c=cy-cy1=0, so daß in Figur 4 die ersten und zweiten Addierer/Subtrahierer 32, 33 aus Fig. 3 entfallen. Da die Werte des akkumulierten Signals acc1 an sich nicht auf negative verzögerungszeiten ∆T führen können, entfällt auch der dritte Addierer/Subtrahierer 36 aus Fig. 3, so daß sich jedes Steuerwort dT direkt aus dem entsprechenden Wert des akkumulierten Signals acc1 bzw. dem aktuellen Inhalt des Akkumulators 34 ergibt. Der Akkumulator repräsentiert mit seinem Inhalt (acc1) also direkt den momentanen Phasenfehler infolge der fractional-N-Teilung und mit seinem Überlaufsignal die Steigung des Phasenfehlers.

Die Bestimmungseinheit 31 weist damit lediglich ein eingangsseitig mit dem Akkumulator 34 verbundenes und vorzugsweise mit dem verzögerten Signal xT getaktetes Latch 37 auf. Das Latch 37, dem das akkumulierte Signal acc1 zugeführt wird, stellt an seinem Ausgang die Steuerworte dT bereit (Bitbreite z.B. 5 Bit). Auf diese Weise werden die Steuerworte dT vorzugsweise in zeitlicher Übereinstimmung mit jeweils einer Flanke des verzögerten Signals xT bereitgestellt, z.B. mit jeweils einer steigenden Flanke von xT. Hierdurch wird eine optimale momentane Korrektur des zeitvarianten Phasenfehlers ermöglicht. Alternativ kann das Latch 37 mit dem frequenzgeteilten Signal xDIV getaktet sein.

Die Steuereinheit 27 bestimmt damit die Steuerworte dT in Abhängigkeit von nur einem vom Sigma-Delta-Modulator bereitgestellten Signal, nämlich dem akkumulierten Signal acc1 und stellt die Steuerworte dT für die Verzögerungseinheit 26 bereit (siehe Fig. 2). Die Werte der Steuerworte dT stimmen hierbei jeweils direkt mit einem Wert des akkumulierten Signals acc1 überein. Vorzugsweise werden auch die Werte des einstellbaren Teilers D von der Steuereinheit 27 aus Fig. 4 in Abhängigkeit von mind. einem vom Sigma-Delta-Modulator 28 bereitgestellten Signal bestimmt, nämlich dem Überlaufsignal (Ausgangssignal) cy.

Aus Fig. 4 ist zu ersehen, daß für die vorliegende Erfindung im einfachsten Falle zum Bestimmen der Werte der Steuerworte dT ein Akkumulator (34) ausreichend ist, der in der Regel zum Bestimmen der Teilerwerte ohnehin erforderlich ist.

Das mit Bezug auf die Figuren 2 und 4 beschriebene zweite Ausführungsbeispiel eines erfindungsgemäßen PLL-Frequenzgenerators ist besonders einfach zu implementieren und im Betrieb besonders energiesparend.

Obgleich die vorliegende Erfindung vorstehend anhand von Ausführungsbeispielen beschrieben wurde, ist sie nicht darauf beschränkt, sondern auf vielfältige Weise modifizierbar. So ist die Erfindung beispielsweise weder auf WPANs an sich, noch auf WPANs gemäß IEEE 802.15.4 bzw. die dort spezifizierten Frequenzbänder, Zielfrequenzwerte, Spektralmasken etc. beschränkt. Auch ist die Erfindung nicht auf eine bestimmte Referenzfrequenz, Frequenzauflösung, eine bestimmte Architektur oder eine bestimmte Ordnung von Sigma-Delta-Modulatoren oder eine bestimmte Architektur der PLL, der verzögerungseinheit, des Frequenzteilers oder der Steuereinheit beschränkt. Die Erfindung kann vielmehr vorteilhaft in unterschiedlichsten drahtlosen oder -gebundenen Kommunikationssystemen eingesetzt werden.

Bezugszeichenliste

| 10 | Datenübertragungssystem / WPAN nach IEEE 802.15.4 |
| 11-13 | Sende-/Empfangsvorrichtung |
| 14 | Antenne |
| 15 | Sende-/Empfangseinheit (transceiver, TRX) |
| 16 | Kontrolleinheit (CTRL) |
| 20 | PLL-Frequenzgenerator |
| 21 | Referenzoszillator |
| 22 | Phasen(differenz)detektor / Ladungspumpe (PD/CP) |
| 23 | Schleifenfilter (loop filter, LF) |
| 24 | spannungsgesteuerter Oszillator (VCO) |
| 25 | schaltbarer Frequenzteiler (DIV) |
| 26 | schaltbare Verzögerungseinheit (DEL) |
| 27 | Steuereinheit |
| 28 | Sigma-Delta-Modulator (ΣΔ) |
| 29 | Addierer |
| 30 | Mapping-Einheit (MAP) |
| 31 | Bestimmungseinheit (DET) |
| 32 | erster Addierer/Subtrahierer |
| 33 | zweiter Addierer/ Subtrahierer |
| 34 | Akkumulator |
| 35 | Auswertungseinheit |
| 36 | dritter Addierer/Subtrahierer |
| 37 | Latch |

| ACC1 | Akkumulator |
| CTRL | Kontrolleinheit |
| DEL | schaltbare Verzögerungseinheit |
| DET | Bestimmungseinheit zum Bestimmen von dT |
| DIV | schaltbarer Frequenzteiler; multi modulus divider |
| EVAL | Auswertungseinheit |
| ISM | industrial, scientific, medical (Frequenzband bei 2,4 GHz) |
| LF | loop filter (Schleifenfilter) |
| MAP | Mapping-Einheit |
| MMD | multi modulus divider |
| PD/CP | Phasendetektor / Ladungspumpe (charge pump) |
| PLL | phase locked loop |
| PN | pseudo-noise |
| QPSK | quarternary phase shift keying |
| TRX | Sende-/Empfangseinheit, transceiver |
| VCO | voltage controlled oscillator (spannungsgesteuerter Oszillator) |
| WPAN | Wireless Personal Area Network |

| Δac | zweites Differenzsignal |
| ΔC | erstes Differenzsignal |
| ΔT | Verzögerungszeit |
| ΣΔ | Sigma-Delta-Modutator |
| acc1 | akkumuliertes Signal |
| CH | Index des gewünschten Kanals im ISM-Band |
| cy | erstes Überlaufsignal |
| cy1 | zweites Überlaufsignal |
| D | Teiler bei der Frequenzteilung |

| dT | Steuerwort |
|---|---|
| fC | Chiptakt |
| fDIV | Frequenz des frequenzgeteilten Signals xDIV |
| FRAC | "gebrochenrationaler" Anteil des Teilers D |
| fREF | Frequenz des Referenzsignals xREF |
| fRF | Zielfrequenz, Frequenz des Ausgangssignals yRF |
| iCP | definierter Strom der Ladungspumpe |
| INT | ganzzahliger Anteil des Teilers D |
| M | Ordnung des Sigma-Delta-Modulators |
| off | Offset |
| t0 | Grundverzögerung |
| ts | Schrittweite der Verzögerung |
| vt | Steuerspannung |
| xDIV | frequenzgeteiltes Signal |
| xREF | Referenzsignal |
| xT | verzögertes Signal |
| yRF | Ausgangssignal des VCO bzw. des PLL-Frequenzgenerators |

**Patentansprüche**

1.  PLL-Frequenzgenerator (20) zum Generieren eines Ausgangssignals (yRF) mit einer einstellbaren Zielfrequenz (fRF), enthaltend:

    a) einen spannungsgesteuerten Oszillator (24) zum Generieren des Ausgangssignals (yRF),
    b) einen mit dem spannungsgesteuerten Oszillator (24) verbundenen schaltbaren Frequenzteiler (25), der ausgebildet ist, aus dem Ausgangssignal (yRF) ein frequenzgeteiltes Signal (xDIV) abzuleiten, dessen Momentanfrequenz (fDIV) von einem Wert eines einstellbaren Teilers (D) abhängt,
    c) eine mit dem Frequenzteiler (25) verbundene schaltbare verzögerungseinheit (26), die ausgebildet ist, ein verzögertes Signal (xT) zu bilden, indem das frequenzgeteilte Signal (xDIV) um Verzögerungszeiten (ΔT) verzögert wird, die jeweils von einem Steuerwort (dT) abhängen,
    d) eine mit der schaltbaren Verzögerungseinheit (26) verbundene Steuereinheit (27), die ausgebildet ist, die Steuerworte (dT) zu bestimmen,
    **dadurch gekennzeichnet, daß**
    e) die Steuereinheit (27) einen Sigma-Delta-Modulator (28) aufweist und ausgebildet ist, die Steuerworte (dT) in Abhängigkeit von mindestens einem vom Sigma-Delta-Modulator bereitgestellten Signal (acc1, cy, cy1) zu bestimmen.

2.  PLL-Frequenzgenerator nach Anspruch 1, **dadurch gekennzeichnet, daß** die Steuereinheit (27) mit dem Frequenzteiler (25) verbunden und ausgebildet ist, die Werte des einstellbaren Teilers (D) in Abhängigkeit von mindestens einem vom Sigma-Delta-Modulator (28) bereitgestellten Signal (acc1, cy, cy1) zu bestimmen.

3.  PLL-Frequenzgenerator nach Anspruch 1 oder 2, **dadurch gekennzeichnet, daß**

    a) der Sigma-Delta-Modulator (28) einen Akkumulator (34) aufweist, der zum Akkumulieren eines Eingangssignals (FRAC) des Sigma-Delta-Modulators und zum Bereitstellen eines akkumulierten Signals (acc1) ausgebildet ist,
    b) die Steuereinheit (27) ausgebildet ist, die Steuerworte (dT) in Abhängigkeit vom akkumulierten Signal (acc1) zu bestimmen.

4.  PLL-Frequenzgenerator nach Anspruch 3, **dadurch gekennzeichnet, daß**

    a) der Akkumulator (34) ausgebildet ist, ein Überlaufsignal (cy1; cy) bereitzustellen,
    b) die Steuereinheit (27) ausgebildet ist, die werte des einstellbaren Teilers (D) in Abhängigkeit vom Überlaufsignal (cy1; cy) zu bestimmen.

5.  PLL-Frequenzgenerator nach einem der Ansprüche 3 oder 4, **dadurch gekennzeichnet, daß** die Steuereinheit (27) einen Sigma-Delta-Modulator (28) erster Ordnung aufweist und ausgebildet ist, die Steuerworte (dT) derart zu bestimmen, daß jedes Steuerwort mit einem wert des akkumulierten Signals (acc1) übereinstimmt.

6. PLL-Frequenzgenerator nach einem der Ansprüche 3 oder 4, **dadurch gekennzeichnet, daß**

 a) die Steuereinheit (27) einen Sigma-Delta-Modulator (28) zweiter oder höherer Ordnung aufweist, der ausgebildet ist, ein erstes Überlaufsignal (cy) und ein zweites Überlaufsignal (cy1) bereitzustellen,
 b) die Steuereinheit (27) ausgebildet ist, die Steuerworte (dT) in Abhängigkeit vom ersten und zweiten Überlaufsignal (cy, cy1) zu bestimmen.

7. PLL-Frequenzgenerator nach Anspruch 6, **dadurch gekennzeichnet, daß** die Steuereinheit (27) ausgebildet ist, die Steuerworte (dT) in Abhängigkeit von einem ersten Differenzsignal ($\Delta c$) aus dem ersten Überlaufsignal (cy) und dem zweiten Überlaufsignal (cy1) zu bestimmen.

8. PLL-Frequenzgenerator nach Anspruch 7, **dadurch gekennzeichnet, daß** die Steuereinheit (27) ausgebildet ist, die Steuerworte (dT) in Abhängigkeit von einem zweiten Differenzsignal ($\Delta ac$) aus dem akkumulierten Signal (acc1) und dem ersten Differenzsignal ($\Delta c$) zu bestimmen.

9. PLL-Frequenzgenerator nach Anspruch 8, **dadurch gekennzeichnet, daß** die Steuereinheit (27) ausgebildet ist, Werte des zweiten Differenzsignals ($\Delta ac$) im Akkumulator (34) zu speichern.

10. PLL-Frequenzgenerator nach Anspruch 8 oder 9, **dadurch gekennzeichnet, daß** jedes Steuerwort (dT) bis auf einen Offsetwert (off) mit je einem Wert des zweiten Differenzsignals ($\Delta ac$) übereinstimmt.

11. PLL-Frequenzgenerator nach einem der Ansprüche 6 bis 10, **dadurch gekennzeichnet, daß** die Steuereinheit (27) zur Bestimmung der Steuerworte (dT) eine mit dem Sigma-Delta-Modulator (28) und der schaltbaren verzögerungseinheit (26) verbundene Bestimmungseinheit (31) mit mindestens einem Addierer/Subtrahierer (32, 33, 36) aufweist.

12. PLL-Frequenzgenerator nach einem der Ansprüche 6 bis 11, **dadurch gekennzeichnet, daß** ein Sigma-Delta-Modulator (28) zweiter Ordnung vorgesehen ist.

13. PLL-Frequenzgenerator nach einem der vorhergehenden Ansprüche, **dadurch gekennzeichnet, daß** die Steuereinheit (27) ausgebildet ist, die Steuerworte (dT) in Abhängigkeit vom verzögerten Signal (xT) bereitzustellen.

14. PLL-Frequenzgenerator nach Anspruch 13, **dadurch gekennzeichnet, daß** die Steuereinheit (27) ausgebildet ist, die Steuerworte (dT) in zeitlicher Übereinstimmung mit jeweils einer Flanke des verzögerten Signals (xT) bereitzustellen.

15. PLL-Frequenzgenerator nach Anspruch 13 oder 14, **dadurch gekennzeichnet, daß** die Steuereinheit (27) zum Bereitstellen der Steuerworte (dT) ein durch das verzögerte Signal (xT) getaktetes Latch (37) aufweist.

16. PLL-Frequenzgenerator nach einem der vorhergehenden Ansprüche, **dadurch gekennzeichnet, daß**

 a) der spannungsgesteuerten Oszillator (24) das Ausgangssignal (yRF) in Abhängigkeit von einer Steuerspannung (vt) generiert, und
 b) der PLL-Frequenzgenerator einen mit der schaltbaren Verzögerungseinheit (26) verbundenen Phasendetektor (22) aufweist, der ausgebildet ist, die Phasendifferenz zwischen einem Referenzsignal (xREF) und dem verzögerten Signal (xT) zu bestimmen und zur Bildung der Steuerspannung (vt) bereitzustellen.

17. PLL-Frequenzgenerator nach Anspruch 16, **dadurch gekennzeichnet, daß** ein mit dem Phasendetektor (22) und dem spannungsgesteuerten oszillator (24) verbundenes Schleifenfilter (23) vorgesehen ist, das ausgebildet ist, die Steuerspannung (vt) zu bilden.

18. Sende-/Empfangsvorrichtung (11-13), insbesondere für ein Datenübertragungssystem (10) nach dem IEEE-Standard 802.15.4, enthaltend eine Antenne (14) sowie eine mit der Antenne verbundene Sende-/Empfangseinheit (15) zum Senden und Empfangen von Daten insbesondere nach IEEE 802.15.4, mit einem PLL-Frequenzgenerator (20) nach einem der Ansprüche 1 bis 17.

19. integrierte Schaltung, insbesondere für eine Sende-/Empfangsvorrichtung nach Anspruch 18, mit einem PLL-Frequenzgenerator (20) nach einem der Ansprüche 1 bis 17.

FIG. 1

FIG. 2

FIG. 3

FIG. 4

**Europäisches Patentamt**

# EUROPÄISCHER RECHERCHENBERICHT

Nummer der Anmeldung

EP 06 02 5399

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2001/036240 A1 (GOSSMANN TIMO [DE] ET AL GOSSMANN TIMO [DE] ET AL) 1. November 2001 (2001-11-01) * Absätze [0020], [0039], [0047] - [0062] * * Abbildungen 2-4 * ----- | 1-5, 13-19 | INV. H03L7/197 H03L7/081 |
| X | WO 2004/088846 A (ERICSSON TELEFON AB L M [SE]; EIKENBROEK JOHANNES WILHELMUS [NL]) 14. Oktober 2004 (2004-10-14) * Seite 1, Zeile 8 - Zeile 25 * * Seite 6, Zeile 16 - Seite 8, Zeile 5 * * Seite 9, Zeile 22 - Seite 12, Zeile 2 * * Abbildungen 2-4,7-10 * ----- | 1-4, 13-19 | |
| A | OWEN D: "A NEW APPROACH TO FRACTIONAL-N SYNTHESIS" ELECTRONIC ENGINEERING, MORGAN-GRAMPIAN LTD. LONDON, GB, Bd. 62, Nr. 759, 1. März 1990 (1990-03-01), Seiten 35-36,38, XP000102103 ISSN: 0013-4902 * Seite 35; Abbildung 1 * ----- | 1-5, 13-19 | RECHERCHIERTE SACHGEBIETE (IPC) H03L |
| A,D | US 6 064 272 A (RHEE WOOGEUN [US]) 16. Mai 2000 (2000-05-16) * Spalte 3, Zeile 29 - Spalte 6, Zeile 44 * * Abbildungen 2-6 * ----- | 1 | |

Der vorliegende Recherchenbericht wurde für alle Patentansprüche erstellt

| Recherchenort | Abschlußdatum der Recherche | Prüfer |
|---|---|---|
| Den Haag | 22. Februar 2007 | Balbinot, Hervé |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.........................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 06 02 5399

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-02-2007

| Im Recherchenbericht angeführtes Patentdokument | Datum der Veröffentlichung | Mitglied(er) der Patentfamilie | Datum der Veröffentlichung |
|---|---|---|---|
| US 2001036240 A1 | 01-11-2001 | WO 0014879 A2 | 16-03-2000 |
| | | DE 19840241 C1 | 23-03-2000 |
| | | EP 1145437 A2 | 17-10-2001 |
| | | JP 3597471 B2 | 08-12-2004 |
| | | JP 2003515963 T | 07-05-2003 |
| WO 2004088846 A | 14-10-2004 | CN 1768479 A | 03-05-2006 |
| | | EP 1609243 A1 | 28-12-2005 |
| US 6064272 A | 16-05-2000 | WO 0002316 A1 | 13-01-2000 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6064272 A